# EUROPEAN PATENT SPECIFICATION

(11) **EP 4 402 494 B1**
(45) Date of publication and mention of the grant of the patent: **11.06.2025**
(21) Application number: 21778015.4
(22) Date of filing: 15.09.2021
(51) Int. Cl.: G01R 31/12, G01R 31/08

(54) **INSULATOR CONDITION MONITORING DEVICE AND CORRESPONDING DATA PROCESSING SYSTEM**
VORRICHTUNG ZUR ÜBERWACHUNG DES ISOLATIONSZUSTANDES UND ENTSPRECHENDES DATENVERARBEITUNGSSYSTEM
DISPOSITIF DE SURVEILLANCE D'ÉTAT D'ISOLATEURS ET SYSTÈME CORRESPONDANT DE TRAITEMENT DE DONNÉES

(43) Date of publication of application: 24.07.2024
(73) Proprietor: CALLIDUS GRUPA d.o.o., 10000 Zagreb (HR)
(72) Inventor: RANOGAJEC, Goran, 10000 Zagreb (HR); SIMEUNOVIC, Mladen, 4000 Kranj (SI); BUDISAVLJEVIC, Damjan, 10000 Zagreb (HR)
(74) Representative: Bihar, Zeljko
(86) International application number: PCT/EP2021/075392
(87) International publication number: WO 2023/041154

(56) References cited:
- EP-A1- 3 361 289
- CN-A- 108 008 237
- CN-A- 108 020 756
- CN-A- 112 531 892
- CN-U- 204 945 307
- CN-U- 210 222 990
- US-A1- 2011 011 621
- US-A1- 2016 209 454
- US-A1- 2017 227 596
- US-A1- 2018 108 461
- US-A1- 2020 401 486

## Description

### Technical Field

The present disclosure relates to an insulator condition monitoring device and the corresponding data processing system. The invention's technical field belongs to testing electric properties in general, and more specifically, it belongs to arrangements for locating electric faults of line insulators or spacers, e.g., ceramic overhead line cap insulators.

### Technical Problem

Insulator condition monitoring represents, among others, a standard routine in every power grid maintenance and checking. It is known in the art that severe environmental and industrial pollution is a concern for electric utilities due possible resulting flashovers and unplanned line outages. In this regard, insulator condition monitoring is a valuable tool to allow maintenance actions, such as washing, to be scheduled when needed. Among the variables that can be monitored, leakage current stands out as the most meaningful since it provides a true measure of how close an insulator string is to flashover. The relationship between leakage current and environmental as well as climatic factors that can impact insulators has therefore attracted much attention. But since this relationship is complex and dynamic it cannot be successfully described using mathematical tools only, even combined with environmental and meteorological data with the help of machine learning.

The present disclosure is therefore oriented toward novel, reliable, cheap, and easy to use condition monitoring device *per se* and the corresponding data processing system. The disclosed monitoring device is equipped with a plurality of sensors used for monitoring electrical and mechanical properties of the insulator and the insulator unit to which is mounted. In addition, each monitoring device is equipped with a low-power wide-area network (LPWAN) unit, capable to exchange the data with one or more LPWAN gateways in a way that does not support full duplex communication and wakening the said devices on the server's demand. Each communication session uses a small fraction of the built-in battery power, and number of transmissions should be minimised in order to preserve the battery lifetime.

The data processing system is designed to monitor a plurality of the above cited monitoring devices that are mounted in geographic areas capable to drastically change environmental properties for one day, which significantly alter the insulator behaviour in the electric sense. So, the first technical problem is the design of the data processing system that is capable to handle the plurality of the monitoring devices in a manner which preserves their batteries, disables false alarms, or prevents devices' rapid data firing especially from new installed devices.

The second technical problem solved with the present invention is the way of combining received data of identical or different set of sensors from two or more monitoring devices. Namely, data corelation, optionally combined with meteorological and geographic data, significantly improves knowledge about the insulators that surpass any mathematical models known in the art. In addition, the corelation among sensor data of single and multiple monitoring devices are used for generating health reports not only for the single insulator but for all power lines under surveillance.

The third technical problem is oriented to the monitoring device *per se*. The device is designed, according to the preferred embodiment, to be attached with the simple cable tie to the insulator, without necessity to disconnect the corresponding line conductor and without need for enclosing the insulator with the measuring coils or transformers.

Finally, the disclosed devices and the corresponding data processing system can be effectively used in a standard control or periodic tests performed on a transmission or distribution lines with a standard high-voltage test methods. In such tests, the data-processing system for monitoring working condition of electric insulators pre-sets one or more devices to respond to performed tests using the sensors and probes of the said devices to further check the condition of the transmission line or to determine the location of faults, without interfering with the results of the said tests.

### State of the Art

The brief review of state of the art is described below.

Document JPS6333670A for the invention SYSTEM FOR MONITORING CONTAMINATION CORONA OF TRANSMISSION LINE, filed in the name of Chubu Electric Power and NGK Insulators Ltd., discloses the device which is mounted directly on the insulator for monitoring purpose. This device has a current transformer which surrounds the insulator and the side mounted Hall probe as well. The device, according to the present invention has more sensors, i.e., an inclination and acceleration sensor, several magnetic field sensors, LPWAN communication unit, etc. The document is silent regarding possible use of correlation among the used sensors from the same or different devices.

Document CN110376427A for the invention ONLINE INTELLIGENT MONITORING DEVICE OF INSULATORS, AND MONITORING METHOD THEREOF, filed in the name of Jiangsu Nanci Insulators Co. Ltd., discloses the device which uses a leakage current collecting device to monitor the insulator condition. This document is selected due to the facts that described device communicate the insulator's condition via a NB-IoT (Narrowband Internet of Things) module that is efficient only in areas with a good coverage of the provider's signal.

Document CN110261750A for the invention POLLUTION FLASHOVER MONITORING DEVICE AND METHOD OF ELECTRIC TRANSMISSION LINE INSULATOR STRING, filed in the name of Yunnan Power Grid Co., Ltd. and Electric Power Research Institute, discloses a yet another monitoring device. As the main sensor, the document mentions clamp-type ammeter that enables a measurement of the current in a conductor without the need to make physical contact with it. The described device is further equipped with a wireless long-distance data transmission module, and with a humidity and a temperature sensor. The document is silent regarding the usage of an acceleration or an inclination sensor for monitoring mechanical parameters or other electromagnetic parameters such as Hall probes, electric field antennas or similar.

Document US 9,244,114 for the invention SYSTEM AND METHOD FOR ASSESSING FAULTY POWER-LINE INSULATOR STRINGS, filed in the name of Metrycom Comm Ltd, discloses the monitoring device which uses current pulse signals which flow in the ground wire, and which are measured by employing a current transformer installed around the ground wire as a clamp. The measured data are sent firstly to the gateway and then through a standard network connection to a server which stores the data and performs further analysis. This document is silent regarding other sensors, and regarding possible use of the correlation data from one or more sensors. However, the described solution does not affect the insulator properties at all.

Document US20190227110A1 for the invention INSULATOR LEAKAGE CURRENT DETECTOR AND METHOD OF DETECTING INSULATOR LEAKAGE CURRENT, filed in the name of Lindsey Mfg. Co., discloses the monitoring device which uses Rogowski coil which encloses the insulator to obtain a derivative of the leakage current. In one embodiment, a transmitting device that is configured to transmit a signal, including the information sensed by the Rogowski coil, away from the insulator leakage current detector is a RFID sensor, because the RFID sensor does not require a separate power source to transmit a signal. Once the information is provided to the RFID system, it can be transmitted further via an iridium satellite radio signal, as mentioned in the description of the said document. This document is silent regarding other sensors and using the correlation data obtained from one or more sensors.

Document CN106353656A for the invention MONITORING METHOD AND MONITORING DEVICE OF INSULATOR FLASHOVER CURRENT, filed in the name of Dongguan Power Supply Bureau Guangdong Power Grid Co. Ltd. *Et Al.,* discloses yet another monitoring device with the Rogowski coil mounted over the insulator. According to the description, the wireless communication module supports General Packet Radio Service (GPRS) and a short message dual channel transmission data and supports multi-center data communication. It is interesting that the cited invention uses an external data processing system to receive the above threshold monitored data, such as the flashover data. This document is silent regarding other sensors and using the correlation data from one or more sensors.

Document US2020225273A1 for the invention POWER LINE SAG MONITORING DEVICE, filed in the name of Schweitzer Engineering Lab Inc., discloses the monitoring device, attached to the powerline, with a plurality of sensors. The input circuitry receives electrical signal(s) from various operating parameter sensor(s), such as an electrical sensor, a radio frequency (RF) antenna, an acoustic sensor, an ultrasonic sensor, a temperature sensor, an accelerometer, a tilt sensor, a current sensor, and the like. In the description, it is mentioned that the monitoring device may provide an alarm when a combination of two or more measurements from operating parameters exceed a combined threshold that is based on each of the two or more operating parameters. Despite the number of sensors, the present invention seems to be silent regarding the use of combination of identical sensors from two or more identical devices for monitoring insulators' properties over the same power line. Furthermore, the disclosed device is oriented solely to a sag monitoring and not to insulator properties monitoring, i.e., it has a mechanical property that is not suitable to be mounted over around the insulator unit, and it is directed to monitor different operating conditions.

Document WO2020114593A1 for the invention MEASURING DEVICE, ELECTRICAL SYSTEM HAVING A MEASURING DEVICE AND METHOD FOR MEASURING A LEAKAGE, filed in the name of SIEMENS AG, discloses a yet another measuring device that is mounted directly onto the insulator. The disclosed solution has a radio transmitter that is self-powered, as well as the rest of the disclosed device, from the leaking currents over the insulator elements. The present invention seems to be silent regarding the use of combination of identical sensors from two or more identical devices for monitoring insulators' properties over the same power line, as well as regarding the use of mechanical sensors such as the acceleration and/or inclination sensors.

Presentation given by the members of La Granja Insulators with the title: SMART SOLUTIONS FOR INSULATOR CONDITION MONITORING, 2019 INMR World Congress, Tucson Arizona, accessible via link:
https://www.inmr.com/smart-solutions-insulator-condition-monitoring-video/
uses purely laboratory testing and artificial intelligence (AI) / machine learning (ML) for monitoring insulator's condition. Since this relationship is complex and dynamic it cannot be successfully depicted using mathematical tools and the above cited presentation proposes a new solution for condition monitoring of insulators based on estimating leakage current from environmental and meteorological data with the help of machine learning. The problem with the cited approach is that it still needs an *in situ* proof by the monitoring device or human supervision.

It is possible to enumerate other systems and methods for analysing the insulators. In that sense, it is instructive to check:
- Development of HV Live Line Testers for Porcelain Insulators Using LoRa Communication (Video presentation) https://www.inmr.com/development-live-line-testers-porcelain-insulators-using-lora-communication/
   where the technique is well described in 9:30 minute of the above cited video; and
- EPRI's RF Sensor Suite (Video presentation) https://www.inmr.com/epris-sensor-suite-video/
   where the current transformer is mounted again around an insulator, as shown in 8:00 minute of the said video.

In the prior art it is possible to find many IoT (Internet of Things) solutions for monitoring the power lines. A good example is the article cited below:
Alhebshi, F., Alnabilsi, H., Alzebaidi, J., Bensenouci, A., Brahimi, T., & Bensenouci, M.-A. (2018). Monitoring the operation of transmission line in a smart grid system through IoT. 2018 15th Learning and Technology Conference (L&T). doi:10.1109/lt.2018.8368498

However, the sensor mounting system and other disadvantages, such as the module(s) power consumption, may prevent the above-described systems real usage on the power grid.

Finally, it seems that the closest prior art is US2011011621A1 for the invention SMART LINK COUPLED TO POWER LINE, filed in the name of Searete LLC, US. The cited document reveals all the method features A.-E. except those explicitly specifically listed set of sensors correlations, taken from the same or different insulator devices, as explained in the rest of the text, examples III, IV and V.

### Summary of the Invention

The disclosed invention is oriented to a method of operating a data-processing system for monitoring the working condition of electric insulators according to claim 1 and the associated data-processing system according to claim 2.

### Description of Figures

Figure 1 depicts standard tower and corresponding power lines and insulators attached thereto.
Figures 2A, 2B and 2C show the insulator composed from insulator units with the monitoring device attached to first insulator unit, from various perspectives.
Figures 3A, 3B and 3C show a single insulator unit with the monitoring device attached to it, again from various perspectives.
Figure 4 depicts the single insulator unit with the monitoring device, with schematically represented sensors and the probe used within.
Figure 5 depicts the monitoring device disclosed herein, with all important functional parts.
Figure 6 depicts the entire system needed for the proper functioning of monitoring the power grid, including meteorological stations, and optionally used grid data server that provides grid's statuses.

### Detailed Description of the Invention

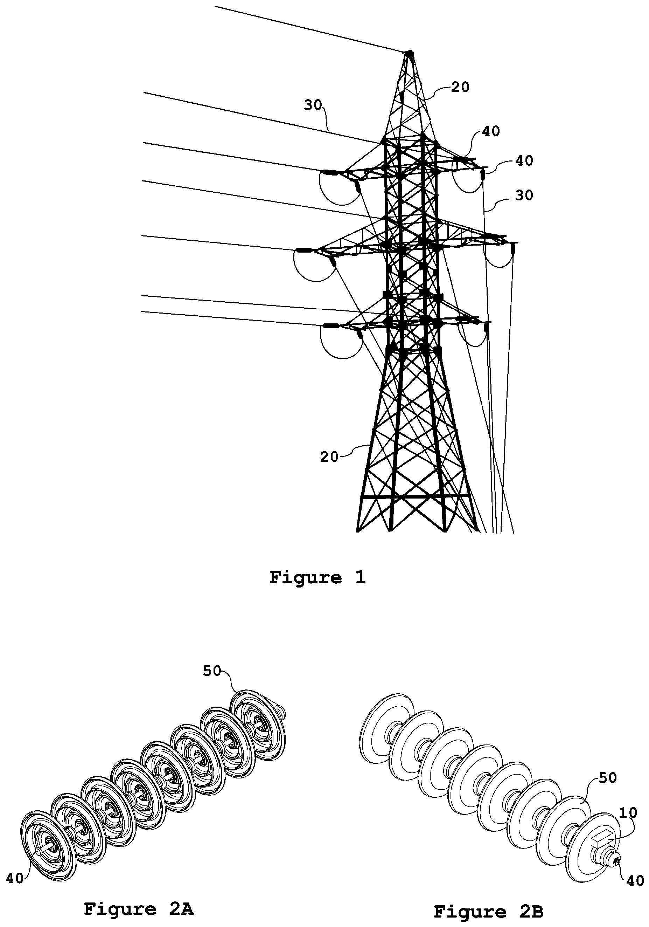

The electric power transmission systems are well known in the art. Figure 1 depicts a standard transmission tower (20), that carries one or more phase conductors (30), and where each conductor (30) is isolated from the tower with set of insulators (40). It is evident that mounting position of the said insulators (40) represents the problem *per se* and is necessary to reduce manpower that is necessary to maintain said insulators (40) in a workable condition that deteriorates in time due to the various factors.

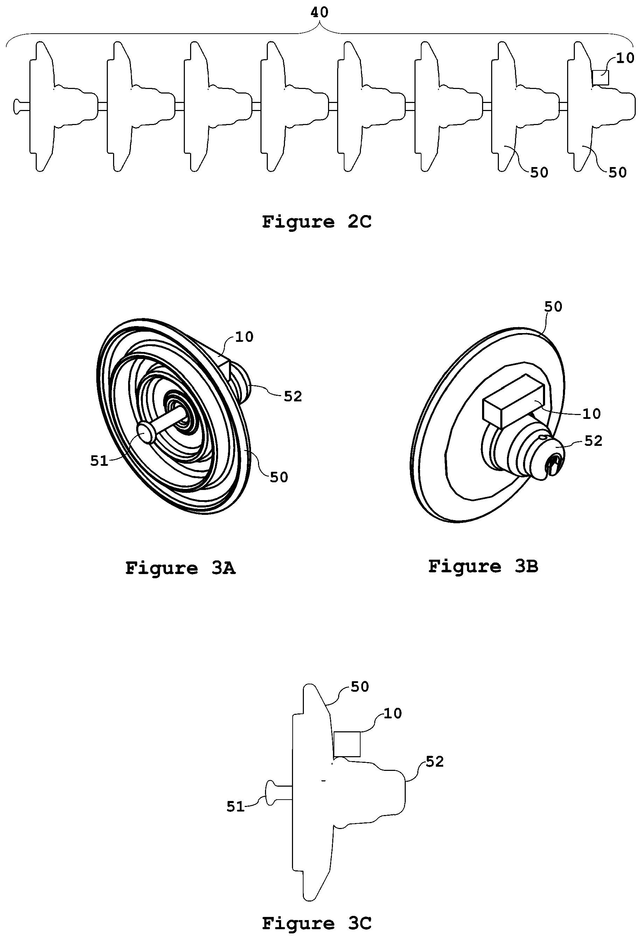

Each insulator (40), depicted on Figures 2A-2C, is composed from number of insulator units (50), where the insulator condition monitoring device (10) is mounted over the outer side of the first insulator unit (50). Plurality of insulator units (50) compose the insulator (40) in a simple and reliable manner, each unit (50) has its pin (51) and the cap (52) that is capable to receive the said pin (51), as depicted in Figures 3A-3C. In this way stacking of the insulator units (50) is achieved, in a manner that is well known in the art, to produce stacked insulator (40) chain or string. The number of used insulating units (50) defines the highest insulating voltage breakdown, e.g., the isolation ability.

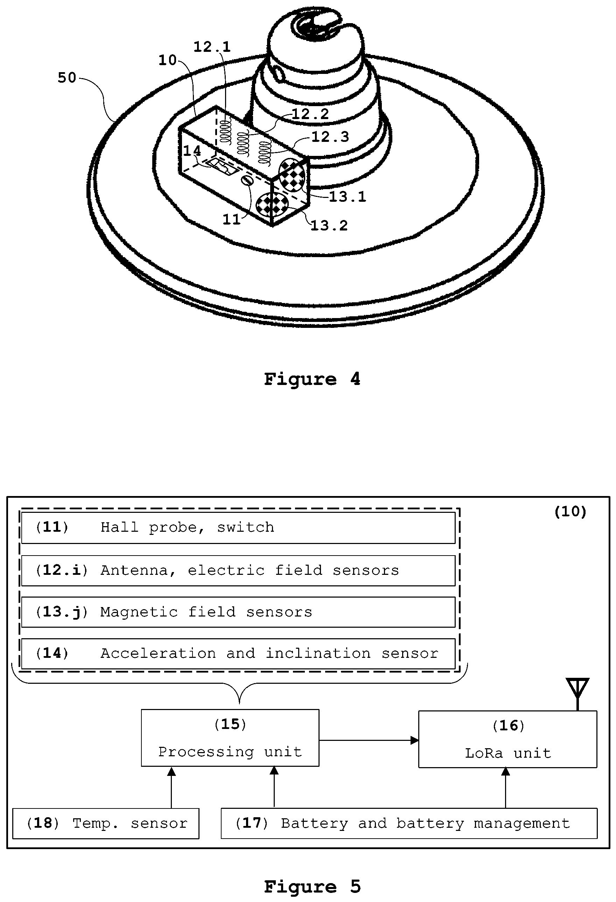

In preferred embodiment, the best position for mounting the monitoring device (10) is at the beginning of the insulator (40), i.e., on the outer side of the first insulating unit (50) where the said device (10) does not alter the insulator (40) properties, that is not the case with all cited prior art. Namely, such mounting affects only the first insulating unit (50), located closely to the transmission tower (20). The actual geometry of such mounting is clearly visible on Figures 3B and 4. The device (10) is conceived as an integral device which is mounted directly to the desired insulator unit (50), without necessity to disconnect the corresponding line conductor (30). Said mounting is performed, preferably via the fastening means such as a cable tie, capable to be tighten via the hot stick designed for the said purpose. The main difference in comparison with the other solutions in the art is that enclosing the insulator unit (50) has nothing with the sensing characteristic of the device (10). Namely, the used fastening means are entirely free from coils, such as the Rogowski coil, or amp clamp meters which require skilled person to assure proper mounting of such devices.

It is also possible to fix the device (10) to an insulator unit (50) via gluing or by using adhesives that hardens once exposed to the ultra-violet light. However, the exchange of the used device (10) may be a potential problem. In practice, the plastic cable tie seems to be the cost-effective approach to the mounting-dismounting problem.

### Insulator condition monitoring device

The insulator condition monitoring device (10) should be reliable, cheap, and easy to use. The monitoring device (10), according to the preferred embodiment, is equipped with the hall probe (11), one or more electric field sensors (12.i), one or more magnetic field sensors (13.j) and the acceleration and inclination sensor (14). Furthermore, the said device (10) has the inner temperature sensor (18). All these sensors and the used probe are connected to the processing unit (15). The battery with its battery management system (17) is designed to supply the necessary power for the operation of the entire device (10). The device (10) has LPWAN (Low Power Wide Area Network) module installed for the communication purpose, that is also connected with the processing unit (15) and the battery with its battery management system (17), as depicted on Figures 4 and 5.

The technical role of hall probe (11) is that is capable to sense electric flashover from the corresponding phase conductor (30) and the tower (20) which holds the same phase conductor (30). The output from said hall probe (11) is basically 0 or 1, and the hall probe has to be chosen in a manner to prevent any low leakage current triggering. In the present invention the hall probe 595-DRV5032FBDBZR, produced by Texas Instruments^{®}, is used.

The technical role of electric field sensors (12.i) is to capture different spectrum parts of the radio frequency (RF) signals generated in vicinity of the said insulator unit (50). Considering the RF spectrum that has to be captured, i.e., from low frequencies up to 100 MHz, it is natural to have more than one RF detector for detecting electric field for various ranges where the antenna geometry basically defines the sensing range. The output from one or more electric field sensors (12.i) can be interpreted after analog-to-digital conversion (ADC) as one byte signal, i.e., 0-255, according to the preferred embodiment. In the present invention, the electric field sensor uses partial discharge antennas, formed on a PCB (Printed Circuit Board), and designed by the applicant.

The technical role of magnetic field sensors (13.j) is to register the magnetic field vector magnitude in the desired orientation in vicinity of the said insulator unit (50). Therefore, it is natural to have more than one magnetic field sensors to measure the magnetic field vector around the device (10). The output from one or more magnetic field sensors (13.j) can be interpreted after analog-to-digital conversion (ADC) as one byte signal, i.e., 0-255, according to the preferred embodiment. In the present invention, the magnetic field sensor is a small Rx Coil unit, model WR221230-36M8-G TDK^{®}.

The technical role of acceleration and inclination sensor (14) is to register any change in inclination and acceleration of the device (10). In addition, the said sensor (14) is provided with a free fall detection and triggering unit, that is found very useful. The free fall detection and triggering unit is used for wakening up the device (10) and alert the data processing system, which will be explained in more details latter. The output from acceleration and inclination sensor (14) can be written in one Byte format, i.e., 0-255, according to the preferred embodiment whilst the triggering signal, that corresponds to free fall detection, is standard 0 or 1 signal. In the present invention, the acceleration and inclination sensors are packed into AIS2IHTR MEMS Accelerometer, Digital, X, Y, Z, ± 2g, ± 4g, ± 8g, ± 16g, 1.62 V, 3.6 V, LGA, Farnell^{®}.

The technical role of temperature sensor (18) is to measure inner device (10) temperature. The output from temperature sensor (18) can be written in one Byte format, i.e., 0-255, according to the preferred embodiment. In the present invention, off-the-shelf generic temperature sensor is used.

The technical role of battery (17) and the corresponding battery management system is well known in the art. According to the preferred embodiment, it is possible to convert the battery status, i.e., the battery voltage, into one Byte format to be transmitted together with other sensors/probe data, such as ID number. In the present invention, the battery and battery management SAFT LS 17500 PFRP, produced by SAFT batteries, is used.

The technical role of low-power wide-area network (LPWAN) unit (17) is to exchange the data with one or more LPWAN gateways (60), that are located 10-15 km away from used device (10). In the preferred embodiment the LoRa module is used. LoRa is a proprietary Low-Power Wide-Area network modulation technique, based on spread spectrum modulation techniques, operating in different sub-GHz bands across the world, and with data rates from 0.3 - 27 kbit/s. Since LoRa defines the lower physical layer, the upper networking layers were lacking. LoRaWAN is one of several protocols that were developed to define the upper layers of the network. LoRaWAN is a cloud-based medium access control (MAC) layer protocol but acts mainly as a network layer protocol for managing communication between LPWAN gateways and end-node devices as a routing protocol, maintained by the LoRa Alliance. LoRaWAN defines the communication protocol and system architecture for the network, while the LoRa physical layer enables the long-range communication link. LoRaWAN is also responsible for managing the communication frequencies, data rate, and power for all devices. It is important to note that devices (17) in the network are asynchronous and transmit when they have data available to send or when triggered by any change of the state. Data transmitted by an end-node device is received by multiple gateways (60.i), which forward the data packets, via the Internet (90) to a centralized network server (80). In the present invention LPWAN unit Lora Module ES0, Murata^{®} is used.

The technical role of processing unit (15) is to collect the data from the above listed probe (11) and sensors (12, 13, 14, 18) and to initiate transmission of the acquired data with the unique ID that defines the device. Having in mind the asynchronous nature of the data transmission over the LPWAN network, e.g., LoRa devices, the processing unit (15) is configured to receive the instructions via LPWAN gateways (60) how to manage the data in the next time frame, immediately after the send session terminates. The said processing unit (15) is configured in a way to be triggered by one or more triggering events to immediately send the data over its LPWAN unit (17). The said triggering events occur when default values of one or more sensors (12, 13, 14, 18) or probe (11) are exceeded, or when predefined time for automatic sending is expired. The processing unit (15) is formed as a simple microcontroller or SoC (system on chip) with modest computational capability in order to preserve the battery (17) lifetime. In the present invention, the processing unit Type ABZ-078, Murata^{®} is used.

Within the above cited configuration, the said device (10) is capable to run autonomously for more than a decade, with one in 24 hours data transmission towards LoRa Gateways (60).

### Other data/service providers

For the normal operation of data processing system (80) other data or service providers are needed.

As mentioned before, a LPWAN gateways, e.g., LoRa gateways (60) are need for the proper operation of monitoring devices (10). Such LoRA gateways should be disposed over the power lines trace to provide a reliable connection with the mentioned devices (10), having in mind the nature of used asynchronous communication via LoRaWAN protocol. Said LoRa gateways (60) are, as mentioned, receiving and transmitting nodes that allow the devices (10) access to the Internet (90) and finally to a server (80) which is used as the data processing system for execution the method described in the details below.

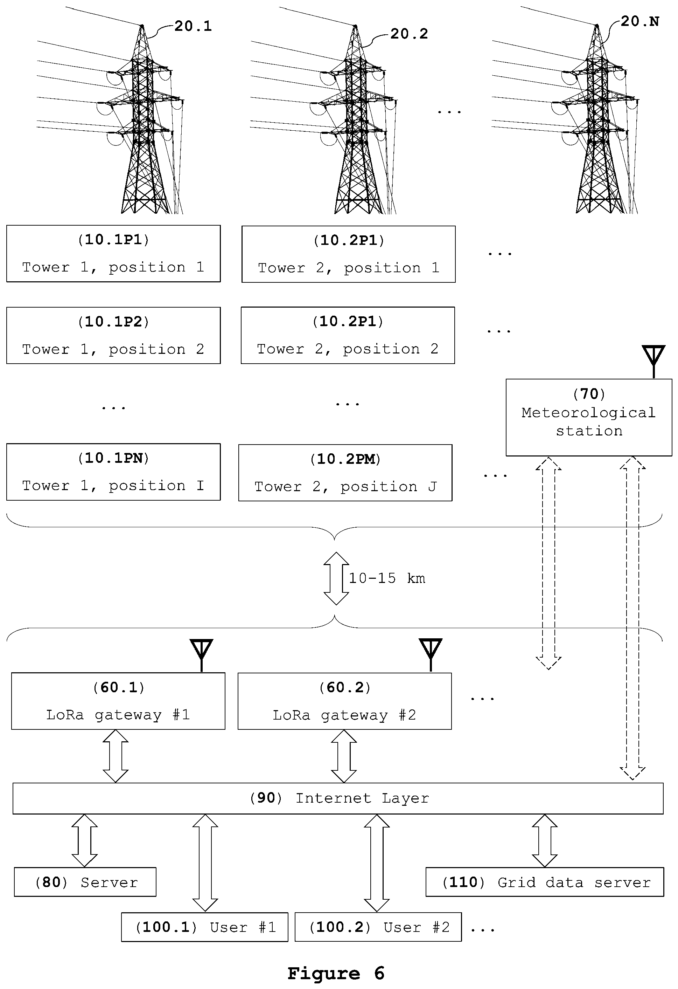

For a reliable monitoring of entire power grid, the important role plays meteorological stations (70) that provide meteorological data for the server (80). Considering the fact that local weather can be accurately predicted via meteorological models, one source of meteorological data, correlated with position, are standard meteorological stations used in any other fields. So, the data are in that case transmitted directly, via the Internet (90), to the server (80), as depicted on Figure 6. Alternatively, a local weather-stations can be mounted over one or more towers (30), that provide accurate temperature and humidity data, transmitted via the LPWAN unit to LPWAN gateways, or via a cellular modem directly to the server (80), using the Internet layer (90) in-between.

Grid data server (110) represents any computer which is capable to provide the grid status data from the grid Supervisory Control and Data Acquisition (SCADA) system in any format, via the Internet layer (90), to the server (80). The access to this data can be delivered in real time or periodically, and it is used in most cases for the event confirmation, once the event has been registered by one or more devices (10).

Server (80) is connected to the Internet layer (90) and carries out the disclosed method. It provides the data to users (100.i), connected to the Internet (90), regarding the working condition of the monitored set of electric insulators (40), once collected from plurality of monitoring devices (10), meteorological stations (70) and, optionally, grid data server (110). It is possible to configure the server (80) to feed the alarm data even with other channels, such as a SMS transmission, an email message, or a push notification to the user (100.i), besides the ordinary signalling regarding the problem.

### Method of operating data-processing system

A method of operating data-processing system for monitoring working condition of electric insulators (40) is carried out via the server (80). According to the invention, the plurality of monitoring devices (10) is disposed over electric insulators (40). Each monitoring device (10) has its ID number used for identification together with other mounting characteristic. This - hard to read ID number - can be connected via the lookup table into easy-to-understand position, e.g., (10.1P1) - that means Tower 1, position 1, as depicted on Figure 6, that is useful for future maintenance and mounting needs.

### STEP A

Before installing any new device (10') it is necessary to pre-set each device (10') with all triggering events disabled. That action prevents instantaneous and rapid data firing towards the server (80) from a newly installed device which occurs due to the wrongly set thresholds. The unique ID is generated for each new device (10') and this ID is recorded with the server (80) together with the future mounting position of the corresponding electric insulator (40), as explained above.

### STEP B

Once the device (10') is mounted, it is activated via the magnetic switch or similar switching device and starts to collect the data that will be sent in a later time at predefined time for send. Once the server (80) receives the data from the new device (10'), in an instant communication between server (80) and device (10'), the server sets a default values for all sensors (12', 13', 14', 18') and the probe (11') for the said device (10') only if received data shows that the current electric insulator (40) and the corresponding phase conductor (30) are operational. This condition is important, otherwise a rapid data firing towards the server (80) is imminent once the power in the corresponding conductor (30) is restored. Finally, the said device (10') becomes the device (10) in further method steps.

The massage format exchanged between any device (10) and the server (80) is a several bytes long vector, as depicted in Table 1 below, where 2 magnetic field sensors and one electric field sensor are used:

**Table 1**

| Probe/Sensor | Min. value | Max. Value |
|---|---|---|
| Hall probe | 0 | 1 |
| El. Field #1 | 0 | 255 |
| Mag. Field #1 | 0 | 255 |
| Mag. Field #2 | 0 | 255 |
| Temperature | 0 | 255 |
| Acceleration | 0 | 1 |
| X - orientation | 0 | 255 |
| Y - orientation | 0 | 255 |
| Z - orientation | 0 | 255 |
| Next send time | 0 | 255 |

The values have different real meanings, for instance Next_send_time = 255 can be interpreted as 24 hours, and Next_send_time = 11 can be interpreted as 1 hour. The relation between one-Byte values and the actual data can be of any form, linear or non-linear. Triggering probes, i.e., Hall probe and free fall detection, has values 0 which refers to disabled and 1 which refers to enabled triggering and instantaneous data sending.

Once the new device (10') is installed, triggering probes are disabled and the device values are set to 0, as depicted below in Table 2.

**Table 2**

| Initialisation | |
|---|---|
| Probe/Sensor | Set value |
| Hall probe | **0 - disabled** |
| El. Field #1 | 0 |
| Mag. Field #1 | 0 |
| Mag. Field #2 | 0 |
| Temperature | 0 |
| Acceleration | **0 - disabled** |
| X - orientation | 0 |
| Y - orientation | 0 |
| Z - orientation | 0 |
| **Next send time** | **11** |

Then, the device starts to collect the data and send the data in predefined timeframe, for instance 1 hour timeframe, as obvious from the above table. After approximately 1 hour, the newly installed device (10') will report back to the server (80) recently measured data, as depicted in Table 3:

**Table 3**

| First measurement data | |
|---|---|
| Probe/Sensor | Measured |
| Hall probe | **0 - disabled** |
| El. Field #1 | 75 |
| Mag. Field #1 | 25 |
| Mag. Field #2 | 2 |
| Temperature | 80 |
| Acceleration | **0 - disabled** |
| X - orientation | 156 |
| Y - orientation | 211 |
| Z - orientation | 7 |
| Next send time | **11** |

If the conductor (30) to which the insulator (40) with newly installed device (10') is powered, and if the data looks acceptable for the server (80), i.e., within the predicted ranges, then, the server (80) sends the following thresholds-data back to the said device (10'), see Table 4:

**Table 4**

| Server instructions for device (10') | |
|---|---|
| Probe/Sensor | Thresholds / triggering |
| Hall probe | **1 - enabled** |
| El. Field #1 | **79** |
| Mag. Field #1 | **27** |
| Mag. Field #2 | **3** |
| Temperature | **84** |
| Acceleration | **1 - enabled** |
| X - orientation | 156 |
| Y - orientation | 211 |
| Z - orientation | 7 |
| Next send time | **255** |

where the threshold values for electrical and magnetic field as well for the temperature are augmented for approx. 5-15% to prevent rapid firing data back, and where the Next_send_time is set to maximum, e.g., 24 hours.

It should be noted that X, Y, Z orientation is not of the vital importance for the system and that the said changes are not able to trigger the system. In other words, these values are duly recorded in the server (80) and compared on each receiving sessions in order to establish any inclination problem. In case of serious problems with the insulator, i.e., the fall of it - the acceleration triggering will do the job. In yet another embodiment, the server (80) can monitor X, Y, Z orientation, and if the newly recorded values deviate significantly, i.e., more than 5% or 10%, the inclination the problem with some insulator (40) is established and the corresponding actions can be triggered from the server's side on the system.

After all of the mentioned sub-steps performed, the new device (10') become the standard installed device (10), which will send the data immediately to the server (80) if:
- the hall probe (11) detects the flashover, or
- the acceleration sensor (14) detects the freefall, or
- if any of the electrical (12.i) and magnetic field (13.j) sensors and temperature sensor (18) exceed the newly set thresholds, or
- when expires the time set for transmission recorded in the Next_send_data variable.

### STEP C

Step C is performed simultaneously with step A. or step B. The server (80) permanently collects data obtained from plurality of devices (10), previously installed on the operational or non-operational part of the grid, which periodically send data to the server (80). This data-collection occurs all the time, the data are recorded for each device (10) in a manner that allows easy history checking data.

### STEP D

In addition to independently working steps A., B. and C., that are rather straightforward for the person skilled in the art, the most important tasks are analytic tasks carried out by the server (80) on data received in step C., data received from one or more meteorological stations (70), and optionally the data received from the grid data server (110), if any. These analytic tasks are listed below:
(i) Server (80) checks newly received values of each sensor or probe on each device (10) alone, combines them with the meteorological data for the said device (10) location and compares the newly received values with the previous recorded values for the same device (10).
(ii) Server (80) checks the correlation of two or more different newly received sensors' values belonging to the same device (10) alone, which are eventually further combined with the meteorological data for the said device (10) location.
(iii) Server (80) checks the correlation of identical set of recently received sensors' values for two or more devices (10, 10', 10", ...) mounted over the electric insulators (40, 40', 40", ...), attached to the same phase conductor (30), on the same or different towers (20, 20', 20", ...).
(iv) Server checks the correlation of identical set of recently received sensors' values for two or more devices (10, 10', 10", ...) mounted over the electric insulators (40, 40', 40", ...) attached to the different phase conductor (30, 30', 30", ...), on the same or different towers (20, 20', 20", ...).

Said analytic task is executed all the time and gives precious data for understanding the situation with the power grin in the field.

### STEP E

Step E. is devoted to the data handling. Each new data obtained in step D. are further used by the server (80):
(i) to update sensors and probe threshold values for the selected device (10) that needs such action and generates the corresponding device (10) health report, in a way that server (80) prioritizes the task to update sensors and probe threshold values for the selected device (10) in order to succeed sending the message back to the selected device (10) while being in receiving mode;
(ii) to generate the most recent health report for each insulator (40) with the recommendations regarding the maintenance, and if necessary, server (80) generates an alarm which is transmitted to one or more predefined users (100);
(iii) to generate the most recent health report for each phase conductor (30); and
(iv) to generate the most recent health report and recommendations for the power line under surveillance.

All above said health reports are accessible by one or more users (100) responsible for monitoring said power line system. In one of further embodiments, the said health reports are eventually indirectly confirmed via data received from the grid data server (110), if such data are available.

### Examples

In the following section, the examples related to the method of operating data-processing system are disclosed in more details.

### Example I - one device, single sensor status

In this example a method of operating data-processing system is revealed. In step D. the server (80) checks newly received values of each sensor or probe mounted on the device (10) alone that has just transmitted data to the server (80). If the newly acquired data are out of expected limits, the following insulator (40) health statuses, carrying the said device (10), are recorded:
- The hall probe (11) activation signalling to one or more causes listed below:
   - a current leakage via the insulator (40) towards the tower (20), or
   - an electric flashover of the insulator (40), or
   - a lightening issue, or
   - a possible pollution presence due to animals' activity or environmental conditions such as dust, pollen, salt, or ash.
   The health status, generated in step E., is that the insulator (40) needs urgent replacement and the alarm to the dedicated user (100) is sent immediately.
- One or more electric field sensors (12.i) record progressive changes in the electrical field in time, when historical data for this particular device (10) are analysed, which is signalling to one or more causes listed below:
   - that the isolator (40) is dirty, or frozen, or salted; or
   - that the dielectric properties of this particular insulator (40) are weaken in time; or
   - the insulator (40) has a corona issue; or
   - the existence of pollution.
   The health status, generated in step E., is that the insulator (40) needs cleaning on the next regular check.
- The acceleration and inclination sensor (14) reports free falling which is signalling to one or more causes listed below:
   - breaking of the insulator (40); or
   - the tower (20) fall issue; or
   - the conductor (30) breaking; or
   - other serious damages of the insulator (40) and/or the corresponding tower (20).
   The health status, generated in step E., is immediate need for checking of the insulator (40) and the corresponding tower (20) and the alarm to the dedicated user (100) is sent immediately.
- The acceleration and inclination sensor (14) reports the change in the orientation, which signalling to one or more causes listed below:
   - a wind issue, or
   - an ice issue.
   The health status, generated in step E. is unchanged, a new increased inclination limits are allowed for an appropriate period of time, and a new inclination data are recorded.
- The temperature sensor (18) reports the values out of the thresholds, which signalling to one or more causes listed below:
   - the presence of fire, high temperature is recorded, or
   - an elevated temperature recorded, possible insulator (40) dielectric breakdown, or
   - a malfunction of some device (10) element.
   The health status, generated in step E., is unchanged, with the provision that on the next regular check this device (10) has to be checked.

### Example II - one device, single sensor status + meteorological data

During the method execution in step D., the server (80) checks particular sensor's data on some device (10) combined with the meteorological data.

If one or more electric field sensors (12.i) record changes in the electrical field that are out of initially set values during the observed increased relative air humidity for some particular device (10); then, the health status, generated in step E., is unchanged. However, the triggering events are adjusted by the server (80) for the said device (10) and sent back to the said device (10), and the server (80) learns behaviour of this particular device (80) for observed humidity values.

### Example III - one device, correlation of sensors' behaviour

During the method execution in step D. the server (80) also checks the correlation of two or more different newly received sensors' values belonging to the same device (10) alone, which are eventually combined with the meteorological data for the said device (10) location. The following health statuses of the insulator (40), carrying the said device (10), are recorded:
- The hall probe (11) is triggered, and one or more electric field sensors (12.i) record changes in the electrical field out of the initially set values, and one or more magnetic field sensors (13.j) record changes that are out of initially set values; such simultaneous recordings signalling to one or more causes listed below:
   - a current leakage through the grounded part, or
   - an insulator (40) breakdown.
   The health status, generated in step E., is need for immediate insulator (40) replacement and the alarm to the dedicated user (100) is sent.
- The hall probe (11) is triggered together with the acceleration and inclination sensor (14) readings which are out of the initially set thresholds; such simultaneous recordings signalling one or more causes listed below:
   - a discharge over the insulator (40), or
   - a physical impact caused by tree, ice or the snow, or
   - a wind issue.
   The health status, generated in step E., is unchanged, with the provision that on the next regular check this insulator (40) has to be checked.
- The hall probe (11) is triggered, and one or more electric field sensors (12.i) record changes in the electrical field that are out of initially set values during the observed increased relative air humidity; such simultaneous recordings signalling:
   - changes in the electric filed, where humidity causes discharge over the insulator (40).
   The health status, generated in step E. is unchanged, with the provision that on the next regular check this insulator (40) has to be checked; with recommendation to perform the electric field measurement at lower humidity, only if the observed values being restored after the recorded incident.
- One or more electric field sensors (12.i) record changes in the electrical field that are out of initially set values together with an anomalous reading of the inner temperature sensor (18); such simultaneous recordings signalling to one or more causes listed below:
   - an electrical field disturbance due to the ionisation and dust particles caused by the fire, or
   - an external meteorological data regarding humidity and temperature are extreme.
   The health status, generated in step E. is unchanged, with the provision that triggering events are adjusted by the server (80) for the said device (10) and send back to it, and the server (80) learns behaviour of this particular device (10) for observed meteorological data.
- The acceleration and inclination sensor (14) reports the change in acceleration and orientation out of the thresholds, together with anomalous reading of the inner temperature sensor (18); such simultaneous recordings signalling to one or more causes listed below:
   - a cracking of the insulator (40), or
   - a cracking of the insulator (40), without short circuits problems if the inner temperature sensor (18) shows T < -20°C, or, T > 35°C and the tower (20) is located in a karst area.
   The health status, generated in step E., is an immediate insulator (40) replacement and the alarm to the dedicated user (100) is sent.
- The acceleration and inclination sensor (14) reports the change in acceleration and orientation out of thresholds, together with anomalous reading of the inner temperature sensor (18), the hall probe (11) is triggered, and one or more electric field sensors (12.i) and one or more magnetic field sensors (13.j) record anomalous changes in the corresponding fields; such simultaneous recordings signalling to the cause below:
   - cracking of the insulator (40).
   The health status, generated in step E., is an immediate insulator (40) replacement and the alarm to the dedicated user (100) is sent.

### Example IV - two or more devices, same conductor

During the method execution in step D. the server (80) checks the correlation of identical set of recently received sensors values for two or more devices (10, 10', 10", ...) mounted over the electric insulators (40, 40', 40", ...), attached to the same phase conductor (30), on the same or different towers (20, 20', 20", ...) and where two by two devices (10, 10') are simultaneously compared.
- When is observed that one or more electrical field sensors (12.i) shows increasing of the electrical filed on the device (10) in time, while the identical set of electrical field sensors (12'.i) shows decreasing of the electrical filed on the device (10') at the same time; such simultaneous recordings signalling to one or more causes listed below:
   - a mechanical damaging of one of insulators (40, 40'), or
   - the tower (20) or the tower (20') grounding issue, or
   - a protective rope breaking.
   The health status, generated in step E., is that the insulators (40, 40') should be checked at the next regular check. If they are in good condition, then the grounding of the pole and the protective ground wire, i.e., the protective rope, must be tested.
- When is observed that one or more electrical field sensors (12.i) shows increasing of the electrical filed magnitude on the device (10) in time, while the identical set of sensors (12.i') shows also increasing of the electrical filed magnitude on the device (10') at the same time; such simultaneous recordings signalling to one or more causes listed below:
   - possible problem on the phase conductor (30); or
   - a storm approaching; or
   - a lightning issues.
   The health status, generated in step E., is that the insulators conditions are good, but it is signaled to the grid operator to check the voltage condition of the power grid.

### Example V - three devices, different conductors

During the method execution in step D. the server (80) checks the correlation of identical set of recently received sensors values for two or more devices (10, 10', 10", ...) mounted over the electric insulators (40, 40', 40", ...) attached to the different phase conductor (30), on the same or different towers (20, 20', 20", ...); where three-by-three devices (10, 10', 10") are used.
- When is observed that identical set of electrical field sensors (12.i) shows increasing of the electrical filed on all three devices (10, 10', 10") mounted on the same tower (20); such simultaneous recordings signalling to one or more causes listed below:
   - lightening stroke to the tower (20); or
   - lightening stroke to the ground wire of the same tower (20).
   The health status, generated in step E., is unchanged, and the insulators (40, 40', 40") needs a regular check.
- When is observed that identical set of electrical field sensors (12.i, 12.i') shows increasing of the electrical field on two devices (10, 10'), and that the same set of electrical filed sensors (12.i") shows decreasing of the electrical field on the third device (10"); such simultaneous recordings signalling to one or more causes listed below:
   - a third insulator (40") issue; or
   - a power transmission line protection issue; or
   - a lightning stroke in one of phase conductors.
   The health status, generated in step E., is unchanged, and the insulator (40") and the power transmission line protection need a check.

The above examples I-V are illustrative examples of the disclosed insulator condition monitoring devices (10, 10', ...) and the corresponding data processing system. The person skilled in the art will immediately recognised the potential of the above-described data processing system and use the same or similar correlations to build even more sophisticated monitoring systems.

### Example VI - using the system in standard control or periodic tests

The installed network of monitoring devices is extremely useful during the execution of a standard control or periodic tests performed on a transmission or distribution line with standard high-voltage test methods.

Firstly, it is necessary that the data-processing system for monitoring working condition of electric insulators, and that is executed on the server (80), pre-sets one or more devices (10, 10', ...) to respond to performed tests. In practice, it means that the sensor or probe threshold can be set to their lowest values possible, so any disturbances in grid will activate one or more dedicated devices (10, 10', ...) and the corresponding sensors, causing a rapid data firing. Normally, such behaviour is not desirable regarding the battery energy conservation, but in this example, it is an advantage and necessary condition to operate.

For instance, once the current is starting to flow across the conductor (30), it is imminent that this will affect the electrical and magnetic fields around the conductors (40, 40', ...) attached to the said conductor. The devices (10, 10', 10", ...) can record these changes and immediately respond if the corresponding thresholds are set to lowest values. In that sense further checks of the transmission line conditions are possible and the system of devices (10, 10', ...) allows the server (80) to determine the location of faults, if any, without interfering with the results of the said tests.

### Industrial Applicability

The present disclosure relates to an insulator condition monitoring device and the corresponding data processing system capable to perform various tasks, beside monitoring insulators. The industrial applicability is therefore obvious.

### Reference numbers

- 10: Monitoring device
- 11: Hall probe
- 12: Electric field sensor
- 13: Magnetic field sensor
- 14: Acceleration and inclination sensor
- 15: Processing unit
- 16: LPWAN, e.g., LoRa unit
- 17: Battery and battery management
- 18: Temperature sensor
- 20: Transmission tower
- 30: Phase conductor
- 40: Insulator
- 50: Insulator unit
- 51: Pin
- 52: Cap
- 60: LPWAN gateway, e.g., LoRa gateway
- 70: Meteorological station
- 80: Server
- 90: Internet Layer
- 100: User
- 110: Grid data server

## Claims

1. A method of operating data-processing system for monitoring working condition of electric insulators (40) formed from plurality of insulator units (50), where said insulators (40) are mounted on one or more transmission towers (20) to insulate one or more phase conductors (30) from the said towers (20); where the said method uses data obtained from monitoring devices (10), fixed on the outer side of selected insulator units (50), and
- where each monitoring device (10) comprises:
(i) a hall probe (11), that is capable of sensing electric flashover from the corresponding phase conductor (30) and the tower (20) which holds the same phase conductor (30);
(ii) one or more electric field sensors (12), for capturing different spectrum parts of the radio frequency (RF) signals generated in the vicinity of the said insulator unit (50);
(iii) one or more magnetic field sensors (13), each capable of registering the magnetic field vector magnitude in the desired orientation in the vicinity of the said insulator unit (50);
(iv) an acceleration and inclination sensor (14), capable of measuring acceleration and inclination data, with a free fall detection;
(v) a device (10) inner temperature sensor (18);
(vi) a low-power wide-area network (LPWAN) unit (17), capable of exchanging the data with one or more LPWAN gateways (60);
(vii) a battery (17) and the corresponding battery management system;
(viii) a processing unit (15) that collects the data from the above listed probes and sensors, transmits the acquired data with the unique ID that defines the device, and immediately after a send session termination receives the instructions via LPWAN gateways (60) from the said data-processing system how to manage the data in the next time frame; where the said processing unit (15) is triggered by one or more triggering events to immediately send the data over its LPWAN unit (17), where the said triggering events occur when default values of one or more sensors (12, 13, 14, 18) are exceeded, or the triggering is initiated by the hall probe (11) or free fall detection (14), or when the predefined time for automatic sending is expired;
- where a set of LPWAN gateways (60) are disposed over the transmission power line under surveillance to assure safe data exchange with the set of monitoring devices (10), each LPWAN gateway (60) is further connected to the Internet (90);
- where meteorological data are obtained from one or more meteorological stations (70), optionally disposed over the transmission towers (20), and connected directly to the Internet layer (90), or via the dedicated LPWAN units to the LPWAN gateways (60);
- optionally, a grid data server (110), which is connected to the Internet layer (90), capable of providing the grid status data from the grid supervisory control and data acquisition (SCADA) system;
- where a server (80), connected to the Internet layer (90), carries out the said method and provides the data to users (100), connected to the Internet (90), regarding the working condition of the monitored set of electric insulators (40) collected from a plurality of monitoring devices (10), meteorological stations (70) and, optionally, grid data server (110);
wherein the said method steps are:
A. pre-setting of each device (10') with all triggering events disabled, the unique ID is generated for the said device (10') and recorded with the server (80) together with the future mounting position of the corresponding electric insulator (40);
B. once the particular device (10') is physically attached to the dedicated insulator unit (50) and activated, the device (10') starts to collect the data and sends the data in predefined time intervals to the server (80), where server (80) turns the triggers on and set default values for all sensors (12', 13', 14', 18') and probe (11') for the said device (10') once the collected device's data shows that the current electric insulator (40) and the corresponding phase conductor (30) are operational, and the device (10') becomes the device (10) in step C.;
C. simultaneously with step A. or step B., the server (80) permanently collects and stores new data obtained from a plurality of devices (10), previously installed on the operational or non-operational part of the grid, which periodically sends data to the server (80);
D. the server (80) permanently carries out analytic tasks, using the newly obtained data in steps C., the data obtained from one or more meteorological stations (70), and optionally the data obtained from the grid data server (110), where the server (80):
- checks the newly received values of each sensor or probe on each device (10) alone, combines the received values with the meteorological data for the said device (10) location, and compares the newly received values with the previously recorded values for the same device (10);
- checks the correlation of two or more different newly received sensor values belonging to the same device (10) alone, and eventually combines said data with the meteorological data for the said device (10) location;
- checks the correlation of an identical set of recently received sensor values for two or more devices (10, 10', 10", ...) mounted over the electric insulators (40, 40', 40", ...), attached to the same phase conductor (30), on the same or different towers (20, 20', 20", ...); and
- checks the correlation of an identical set of recently received sensor values for two or more devices (10, 10', 10", ...) mounted over the electric insulators (40, 40', 40", ...) attached to the different phase conductors (30, 30', 30" ...), on the same or different towers (20, 20', 20", ...);
E. each new data obtained in step D. is used by the server (80):
- to update sensors and probe threshold values for the selected device (10) that needs such action and generates the corresponding device (10) health report, in a way that server (80) prioritizes the task to update sensors and probe threshold values for the selected device (10) in order to succeed sending the message back to the selected device (10) while being in receiving mode;
- to generate the most recent health report for each insulator (40) with the recommendations regarding the maintenance, and if necessary, server (80) generates an alarm which is transmitted to one or more predefined users (100);
- to generate the most recent health report for each phase conductor (30); and
- to generate the most recent health report and recommendations for the power line under surveillance;
where all above said health reports are accessible by one or more users (100) responsible for monitoring said power line system, and where the said health reports are eventually indirectly confirmed via data received from the grid data server (110), if available;
where the said method is **characterized by** that in step D.:
I.) the server (80) checks the correlation of two or more different newly received sensor values belonging to the same device (10) and the following health statuses of the insulator (40), carrying the said device (10), are recorded:
- the hall probe (11) is triggered, and one or more electric field sensors (12.i) record changes in the electrical field out of initially set values, and one or more magnetic field sensors (13.j) record changes out of initially set values; such simultaneous recordings signalling to one or more causes listed below:
(i) a current leakage through the grounded part, or
(ii) an insulator (40) breakdown,
where the health status, generated in step E., is immediate insulator (40) replacement and the alarm to the dedicated user (100) is sent;
- the hall probe (11) is triggered together with the acceleration and inclination sensor (14) readings which are out of the initially set thresholds; such simultaneous recordings signalling to one or more causes listed below:
(i) a discharge over the insulator (40), or
(ii) a physical impact caused by tree, ice or the snow, or
(iii) a wind issue,
where the health status, generated in step E., is unchanged, with the provision that on the next regular check this insulator (40) has to be checked;
- the hall probe (11) is triggered, one or more electric field sensors (12.i) record changes in the electrical field that are out of initially set values during the observed increased relative air humidity; such simultaneous recordings signalling to:
(i) changes in the electric filed, where humidity causes discharge over the insulator (40);
where the health status, generated in step E. is unchanged, with the provision that on the next regular check this insulator (40) has to be checked; with recommendation to perform the electric field measurement at lower humidity, only if the observed values being restored after the recorded incident;
- one or more electric field sensors (12.i) record changes in the electrical field that are out of initially set values together with the anomalous reading of the inner temperature sensor (18); such simultaneous recordings signalling to one or more causes listed below:
(i) an electrical field disturbance due to the ionisation and dust particles caused by the fire, or
(ii) an external meteorological data regarding humidity and temperature are extreme,
where the health status, generated in step E. is unchanged, with the provision that triggering events are adjusted by the server (80) for the said device (10) and send back to it, and the server (80) learns behaviour of this particular device (80) for observed meteorological data;
- the acceleration and inclination sensor (14) reports the change in acceleration and orientation out of the thresholds, together with anomalous reading of the inner temperature sensor (18); such simultaneous recordings signalling to one or more causes listed below:
(i) a cracking of the insulator (40), or
(ii) a cracking of the insulator (40), without short circuits problems if the inner temperature sensor (18) shows T<-20°C, or, T>35°C and the tower (20) is located in a karst area;
where the health status, generated in step E., is an immediate insulator (40) replacement and the alarm to the dedicated user (100) is sent;
- the acceleration and inclination sensor (14) reports the change in acceleration and orientation out of thresholds, together with anomalous reading of the inner temperature sensor (18), the hall probe (11) is triggered, and one or more electric field sensors (12.i) and one or more magnetic field sensors (13.j) record anomalous changes in the corresponding fields; such simultaneous recordings signalling to the cause below:
(i) cracking of the insulator (40),
where the health status, generated in step E., is an immediate insulator (40) replacement and the alarm to the dedicated user (100) is sent.
**or**
**II.)** the server (80) checks the correlation of identical set of recently received sensors values for two or more devices (10, 10', 10", ...) mounted over the electric insulators (40, 40', 40", ...), attached to the same phase conductor (30), on the same or different towers (20, 20', 20", ...); where two-by-two devices (10, 10') are compared:
- when is observed that one or more electrical field sensors (12.i) shows increasing of the electrical filed on the device (10) in time, while the identical set of electrical field sensors (12.i') shows decreasing of the electrical filed on the device (10') in the same time; such simultaneous recordings signalling one or more causes listed below:
(i) a mechanical damaging of one of insulators (40, 40'), or
(ii) the tower (20) or the tower (20') grounding issue, or
(iii) a protective rope breaking,
where the health status, generated in step E., is that the insulators (40, 40') needs cleaning or at least visual inspection on the next check;
- when is observed that one or more electrical field sensors (12.i) shows increasing of the electrical filed magnitude on the device (10) in time, while the identical set of electric field sensors (12.i') shows also increasing of the electrical filed magnitude on the device (10') at the same time; such simultaneous recordings signalling to one or more causes listed below:
(i) a possible problem on the phase conductor (30); or
(ii) a storm approaching; or
(iii) a lightning issue,
where the health status, generated in step E., is that the insulators conditions are good, but it is signaled to the grid operator to check the voltage condition of the power grid.
**or**
**III.)** the server (80) checks the correlation of identical set of recently received sensors values for two or more devices (10, 10', 10", ...) mounted over the electric insulators (40, 40', 40", ...) attached to the different phase conductor (30, 30', ...), on the same or different towers (20, 20', 20", ...); where three-by-three devices (10, 10', 10") are used;
- when is observed that identical set of electrical field sensors (12.i) shows increasing of the electrical filed on all three devices (10, 10', 10") mounted on the same tower (20); such simultaneous recordings signalling to one or more causes listed below:
(i) lightening stroke to the tower (20); or
(ii) lightening stroke to the ground wire of the same tower (20);
where the health status, generated in step E., is unchanged, and the insulators (40, 40', 40") need a regular check;
- when is observed that an identical set of electrical field sensors (12.i, 12.i') shows increasing of the electrical field on two devices (10, 10'), and that the same set of electrical filed sensors (12.i") shows decreasing of the electrical field on the third device (10"); such simultaneous recordings signalling to one or more causes listed below:
(i) a third insulator (40") issue; or
(ii) a power transmission line protection issue; or
(iii) a lightning stroke in one of the phase conductors;
where the health status, generated in step E., is unchanged, and the insulators (40") and the power transmission line protection need a check.

2. A data-processing system for monitoring the working condition of electric insulators (40) comprising means for carrying out the method of claim 1.

## Patentansprüche

1. Verfahren zum Betreiben eines Datenverarbeitungssystems zur Überwachung des Arbeitszustands von elektrischen Isolatoren (40), die aus einer Vielzahl von Isolatoreinheiten (50) gebildet sind, wobei die Isolatoren (40) an einem oder mehreren Sendetürmen (20) angebracht sind, um einen oder mehrere Phasenleiter (30) von den Türmen (20) zu isolieren; wobei das Verfahren Daten verwendet, die von Überwachungsvorrichtungen (10) erhalten werden, die an der Außenseite ausgewählter Isolatoreinheiten (50) befestigt sind, und
- wobei jede Überwachungsvorrichtung (10) umfasst:
(i) eine Hallsonde (11), die in der Lage ist, einen elektrischen Überschlag vom entsprechenden Phasenleiter (30) und dem Turm (20), der denselben Phasenleiter (30) hält, wahrzunehmen;
(ii) einen oder mehrere elektrische Feldsensoren (12) zum Erfassen verschiedener Spektralanteile der in der Nähe der Isolatoreinheit (50) erzeugten Hochfrequenzsignale (RF);
(iii) einen oder mehrere Magnetfeldsensoren (13), die jeweils in der Lage sind die Magnetfeldvektorgröße in der gewünschten Ausrichtung in der Nähe der Isolatoreinheit (50) zu registrieren;
(iv) einen Beschleunigungs- und Neigungssensor (14), der in der Lage ist Beschleunigungs- und Neigungsdaten mit einer Freifallerkennung zu messen;
(v) eine Vorrichtung (10) mit Innentemperatursensor (18);
(vi) eine Low-Power-Wide-Area-Network-, (LPWAN)-Einheit (17), die in der Lage ist die Daten mit einem oder mehreren LPWAN-Gateways (60) auszutauschen;
(vii) eine Batterie (17) und das entsprechende Batteriemanagementsystem;
(viii) eine Verarbeitungseinheit (15), welche die Daten von den zuvor aufgelisteten Sonden und Sensoren sammelt, die erfassten Daten mit der eindeutigen ID, welche die Vorrichtung definiert, überträgt und unmittelbar nach Beendigung einer Sendesitzung über LPWAN-Gateways (60) von dem Datenverarbeitungssystem Anweisungen empfängt, wie die Daten im nächsten Zeitrahmen zu verwalten sind; wobei die Verarbeitungseinheit (15) durch ein oder mehrere auslösende Ereignisse ausgelöst wird, um die Daten umgehend über ihre LPWAN-Einheit (17) zu senden, wobei die auslösenden Ereignisse auftreten, wenn Standardwerte eines oder mehrerer Sensoren (12, 13, 14, 18) überschritten werden, oder die Auslösung durch die Hallsonde (11) oder die Freifallerkennung (14) initiiert wird, oder wenn die vordefinierte Zeit für automatisches Senden abgelaufen ist;
- wobei ein Satz von LPWAN-Gateways (60) über der Übertragungsstromleitung unter Überwachung angeordnet sind, um einen sicheren Datenaustausch dem Satz von Überwachungsvorrichtungen (10) zu gewährleisten, wobei jedes LPWAN-Gateway (60) weiter mit dem Internet (90) verbunden ist;
- wobei meteorologische Daten von einer oder mehreren meteorologischen Stationen (70) erhalten werden, die optional über den Sendetürmen (20) angeordnet und direkt mit der Internetschicht (90) oder über die dedizierten LPWAN-Einheiten mit den LPWAN-Gateways (60) verbunden sind;
- optional einen Netzdatenserver (110), der mit der Internetschicht (90) verbunden ist und zum Bereitstellen der Netzstatusdaten aus dem Netzüberwachungs-, Steuerungs- und Datenerfassungssystem (SCADA-System) in der Lage ist;
- wobei ein mit der Internetschicht (90) verbundener Server (80) das Verfahren ausführt und den mit dem Internet (90) verbundenen Benutzern (100) die Daten hinsichtlich des Arbeitszustands des überwachten Satzes elektrischer Isolatoren (40) bereitstellt, die von einer Vielzahl von Überwachungsvorrichtungen (10), meteorologischen Stationen (70) und optional einem Netzdatenserver (110) gesammelt wurden;
wobei die Verfahrensschritte sind:
a) Voreinstellen jeder Vorrichtung (10'), bei der alle auslösenden Ereignisse deaktiviert sind, wobei die eindeutige ID für die Vorrichtung (10') generiert und zusammen mit der zukünftigen Montageposition des entsprechenden elektrischen Isolators (40) auf dem Server (80) gespeichert wird;
b) sobald die bestimmte Vorrichtung (10') physisch an der dedizierten Isolatoreinheit (50) angebracht und aktiviert ist, beginnt die Vorrichtung (10') damit, die Daten zu sammeln, und sendet die Daten in vordefinierten Zeitintervallen an den Server (80), wo der Server (80) die Auslöser einschaltet und Standardwerte für alle Sensoren (12', 13', 14', 18') und die Sonde (11') für die Vorrichtung (10') einstellt, sobald die gesammelten Daten der Vorrichtung zeigen, dass der aktuelle elektrische Isolator (40) und der entsprechende Phasenleiter (30) betriebsbereit sind, und die Vorrichtung (10') zur Vorrichtung (10) in Schritt C wird;
c) gleichzeitig mit Schritt A. oder Schritt B. sammelt und speichert der Server (80) permanent neue Daten, die er von einer Vielzahl von Vorrichtungen (10) erhält, die zuvor auf dem betriebsbereiten oder nicht betriebsbereiten Teil des Netzes installiert wurden und die periodisch Daten an den Server (80) senden;
d) der Server (80) führt unter Verwendung der in Schritt C. neu erhaltenen Daten, der von einer oder mehreren meteorologischen Stationen (70) erhaltenen Daten und optional der vom Netzdatenserver (110) erhaltenen Daten permanent analytische Aufgaben aus, wobei der Server (80):
- die neu empfangenen Werte jedes Sensors oder jeder Sonde an jeder Vorrichtung (10) allein überprüft, die empfangenen Werte mit den meteorologischen Daten für den Standort der Vorrichtung (10) kombiniert und die neu empfangenen Werte mit den zuvor aufgezeichneten Werten für dieselbe Vorrichtung (10) vergleicht;
- die Korrelation von zwei oder mehr verschiedenen, neu empfangenen Sensorwerten allein überprüft, die nur zu derselben Vorrichtung (10) gehören, und die Daten schließlich mit den meteorologischen Daten für den Standort der Vorrichtung (10) kombiniert;
- die Korrelation eines identischen Satzes von kürzlich empfangenen Sensorwerten für zwei oder mehr Vorrichtungen (10, 10', 10", ...) überprüft, die über den elektrischen Isolatoren (40, 40', 40", ...), die an denselben Phasenleiter (30) angebracht sind, auf denselben oder verschiedenen Türmen (20, 20' , 20", ...) montiert sind; und
- die Korrelation eines identischen Satzes von kürzlich empfangenen Sensorwerten für zwei oder mehr Vorrichtungen (10, 10', 10", ...) überprüft, die über den elektrischen Isolatoren (40, 40', 40", ...), die an den verschiedenen Phasenleitern (30, 30', 30", ...) angebracht sind, auf denselben oder verschiedenen Türmen (20, 20', 20", ...) montiert sind;
e) alle in Schritt D. erhaltenen neuen Daten werden vom Server (80) verwendet:
- um Sensoren und Sondenschwellenwerte für die ausgewählte Vorrichtung (10) zu aktualisieren, die eine solche Aktion benötigt, und den entsprechenden Zustandsbericht für die Vorrichtung (10) erzeugt, sodass der Server (80) der Aufgabe, Sensoren und Sondenschwellenwerte für die ausgewählte Vorrichtung (10) zu aktualisieren, Priorität einräumt, um die Nachricht erfolgreich an die ausgewählte Vorrichtung (10) zurückzusenden, während sie sich im Empfangsmodus befindet;
- um den neuesten Zustandsbericht für jeden Isolator (40) mit den Empfehlungen hinsichtlich der Wartung zu erzeugen, und falls notwendig, erzeugt der Server (80) einen Alarm, der an einen oder mehrere vordefinierte Benutzer (100) übertragen wird;
- um den neuesten Zustandsbericht für jeden Phasenleiter (30) zu erzeugen; und
- um den neuesten Zustandsbericht und Empfehlungen für die unter Überwachung befindliche Stromleitung zu erzeugen;
wobei alle zuvor genannten Zustandsberichte für einen oder mehrere Benutzer (100) zugänglich sind, die für die Überwachung des Stromleitungssystems verantwortlich sind, und wobei die Zustandsberichte schließlich indirekt durch Daten bestätigt werden, die, sofern verfügbar, vom Netzdatenserver (110) empfangen werden;
wobei das Verfahren **dadurch gekennzeichnet ist, dass** in Schritt D.:
I.) der Server (80) die Korrelation von zwei oder mehr verschiedenen neulich empfangenen Sensorwerten überprüft, die zur selben Vorrichtung (10) gehören, und die folgenden Gesundheitszustände des Isolators (40), der die Vorrichtung (10) trägt, aufgezeichnet werden:
- die Hallsonde (11) ausgelöst wird, und ein oder mehrere elektrische Feldsensoren (12.i) Änderungen des elektrischen Feldes außerhalb der ursprünglich eingestellten Werte erfassen, und ein oder mehrere Magnetfeldsensoren (13.j) Änderungen außerhalb der ursprünglich eingestellten Werte erfassen;
wobei solche gleichzeitigen Aufzeichnungen eine oder mehrere der nachfolgend ausgelisteten Ursachen signalisieren:
(i) einen Kriechstrom durch das geerdete Teil, oder
(ii) einen Ausfall des Isolators (40),
wobei der in Schritt E. erzeugte Gesundheitszustand einen sofortigen Austausch des Isolators (40) und die Sendung eines Alarms an den dedizierten Benutzer (100) zur Folge hat;
- die Hallsonde (11) zusammen mit den Messungen des Beschleunigungs- und Neigungssensors (14) ausgelöst wird, die außerhalb der ursprünglich eingestellten Schwellenwerte liegen; wobei solche gleichzeitigen Aufzeichnungen eine oder mehrere der nachfolgend aufgelisteten Ursachen signalisieren:
(i) eine Entladung über den Isolator (40) oder
(ii) eine physische Einwirkung durch einen Baum, Eis oder Schnee, oder
(iii) ein Windproblem,
wobei der in Schritt E. erzeugte Gesundheitszustand mit der Maßgabe unverändert bleibt, dass bei der nächsten regelmäßigen Überprüfung dieser Isolator (40) zu überprüfen ist;
- die Hallsonde (11) ausgelöst wird, ein oder mehrere elektrische Feldsensoren (12.i) während der beobachteten erhöhten relativen Luftfeuchtigkeit Veränderungen des elektrischen Feldes aufzeichnen, die außerhalb der ursprünglich eingestellten Werte liegen; wobei solche gleichzeitigen Aufzeichnungen signalisieren:
(i) Veränderungen im elektrischen Feld, wobei Feuchtigkeit eine Entladung über den Isolator (40) bewirkt;
wobei der in Schritt E. erzeugte Gesundheitszustand mit der Maßgabe unverändert bleibt, dass bei der nächsten regelmäßigen Überprüfung dieser Isolator (40) zu überprüfen ist; mit der Empfehlung, die Messung des elektrischen Feldes bei niedrigerer Feuchtigkeit nur dann durchzuführen, wenn die beobachteten Werte nach dem aufgezeichneten Vorfall wiederhergestellt werden;
- ein oder mehrere elektrische Feldsensoren (12.i) Veränderungen im elektrischen Feld aufzeichnen, die zusammen mit dem anomalen Messwert des inneren Temperatursensors (18) von den ursprünglich eingestellten Werten abweichen; wobei solche gleichzeitigen Aufzeichnungen eine oder mehrere der nachfolgend aufgelisteten Ursachen signalisieren:
i) eine Störung des elektrischen Feldes aufgrund der durch das Feuer verursachten Ionisierung und Staubpartikel, oder
(ii) externe meteorologische Daten bezüglich Luftfeuchtigkeit und Temperatur sind extrem,
wobei der in Schritt E. erzeugte Gesundheitszustand mit der Maßgabe unverändert bleibt, dass auslösende Ereignisse vom Server (80) für die Vorrichtung (10) angepasst und an diese zurückgesendet werden, und der Server (80) das Verhalten dieser bestimmten Vorrichtung (80) für beobachtete meteorologische Daten lernt;
- der Beschleunigungs- und Neigungssensor (14) die Änderung der Beschleunigung und der Ausrichtung außerhalb der Schwellenwerte zusammen mit anomalen Messungen des Innentemperatursensors (18) meldet; wobei diese gleichzeitigen Aufzeichnungen eine oder mehrere der nachfolgend aufgelisteten Ursachen signalisieren:
(i) eine Rissbildung im Isolator (40), oder
(ii) eine Rissbildung im Isolator (40), ohne Kurzschlussprobleme, wenn der Innentemperatursensor (18) T<-20 °C oder T>35 °C anzeigt, und der Turm (20) sich in einem Karstgebiet befindet;
wobei der in Schritt E. erzeugte Gesundheitszustand den sofortigen Austausch des Isolators (40) und die Sendung eines Alarms an den dedizierten Benutzer (100) zur Folge hat;
- der Beschleunigungs- und Neigungssensor (14) die Änderung der Beschleunigung und der Ausrichtung außerhalb von Schwellenwerten zusammen mit einer anomalen Messung des Innentemperatursensors (18) meldet, die Hallsonde (11) ausgelöst wird, und ein oder mehrere elektrische Feldsensoren (12.i) und ein oder mehrere Magnetfeldsensoren (13.j) anomale Änderungen in den entsprechenden Feldern aufzeichnen; wobei diese gleichzeitigen Aufzeichnungen die folgende Ursache signalisieren:
(i) Rissbildung im Isolator (40),
wobei der in Schritt E. erzeugte Gesundheitszustand den sofortigen Austausch des Isolators (40) und die Sendung eines Alarms an den dedizierten Benutzer (100) zur Folge hat.
**oder**
**II.)** der Server (80) die Korrelation identischer Sätze von neulich empfangenen Sensorwerten für zwei oder mehr Vorrichtungen (10, 10', 10", ...), die über den elektrischen Isolatoren (40, 40', 40", ...), die an denselben Phasenleiter (30) angebracht sind, auf denselben oder verschiedenen Türmen (20, 20', 20", ...) montiert sind, überprüft; wobei jeweils zwei verbundene Vorrichtungen (10, 10') verglichen werden:
- wenn beobachtet wird, dass ein oder mehrere elektrische Feldsensoren (12.i) mit der Zeit eine Erhöhung des elektrischen Feldes an der Vorrichtung (10) zeigen, während der identische Satz elektrischer Feldsensoren (12.i') zur gleichen Zeit eine Abnahme des elektrischen Feldes an der Vorrichtung (10') zeigt; wobei solche gleichzeitigen Aufzeichnungen eine oder mehrere der nachfolgend aufgelisteten Ursachen signalisieren:
(i) eine mechanische Beschädigung eines der Isolatoren (40, 40'), oder
(ii) ein Problem mit dem Turm (20) oder der Erdung des Turms (20'), oder
(iii) einen Bruch eines Schutzseils,
wobei der in Schritt E. erzeugte Gesundheitszustand bedeutet, dass die Isolatoren (40, 40') bei der nächsten Überprüfung gereinigt oder zumindest einer Sichtprüfung unterzogen werden müssen;
- wenn beobachtet wird, dass ein oder mehrere elektrische Feldsensoren (12.i) mit der Zeit eine Erhöhung der elektrischen Feldgröße an der Vorrichtung (10) zeigen, während der identische Satz elektrischer Feldsensoren (12.i') zur gleichen Zeit ebenfalls eine Erhöhung der elektrischen Feldgröße an der Vorrichtung (10') zeigt; wobei solche gleichzeitigen Aufzeichnungen eine oder mehrere der nachfolgend aufgelisteten Ursachen signalisieren:
i) ein mögliches Problem am Phasenleiter (30); oder
(ii) ein herannahendes Gewitter; oder
(iii) ein Blitzschlagproblem,
wobei der in Schritt E. erzeugte Gesundheitszustand bedeutet, dass der Zustand der Isolatoren gut ist, aber dem Netzbetreiber signalisiert wird, den Spannungszustand des Stromnetzes zu überprüfen.
**oder**
**III.)** der Server (80) die Korrelation identischer Sätze von neulich empfangenen Sensorwerten für zwei oder mehr Vorrichtungen (10, 10', 10", ...), die über den elektrischen Isolatoren (40, 40', 40,", ...), die an den verschiedenen Phasenleitern (30, 30', ...) angebracht sind, auf denselben oder verschiedenen Türmen (20, 20', 20", ...) montiert sind überprüft; wobei jeweils drei verbundene Vorrichtungen (10, 10', 10") verwendet werden;
- wenn beobachtet wird, dass ein identischer Satz elektrischer Feldsensoren (12.i) an allen drei Vorrichtungen (10, 10', 10"), die auf demselben Turm (20) montiert sind, eine Erhöhung des elektrischen Feldes anzeigt; wobei solche gleichzeitigen Aufzeichnungen eine oder mehrere der nachfolgend aufgelisteten Ursachen signalisieren:
(i) Blitzschlag auf den Turm (20); oder
(ii) Blitzschlag am Erdungskabel desselben Turms (20);
wobei der in Schritt E. erzeugte Gesundheitszustand unverändert bleibt und die Isolatoren (40, 40', 40") eine regelmäßige Überprüfung benötigen
- wenn beobachtet wird, dass ein identischer Satz elektrischer Feldsensoren (12.i, 12.i') eine Erhöhung des elektrischen Feldes an zwei Vorrichtungen (10, 10') zeigt, und dass derselbe Satz elektrischer Feldsensoren (12.i") eine Abnahme des elektrischen Feldes an der dritten Vorrichtung (10") zeigt; wobei solche gleichzeitigen Aufzeichnungen eine oder mehrere der nachfolgend aufgelisteten Ursachen signalisieren:
(i) ein Problem mit dem dritten Isolator (40"); oder
(ii) ein Problem mit dem Schutz der Stromübertragungsleitung; oder
(iii) einen Blitzschlag in einem der Phasenleiter; wobei der in Schritt E. erzeugte Gesundheitszustand unverändert bleibt, und die Isolatoren (40") und der Schutz der Stromübertragungsleitung eine Überprüfung benötigen.

2. Datenverarbeitungssystem zur Überwachung des Arbeitszustands von elektrischen Isolatoren (40), das Mittel zur Ausführung des Verfahrens nach Anspruch 1 umfasst.

## Revendications

1. Procédé de fonctionnement d'un système de traitement de données pour surveiller l'état de fonctionnement d'isolateurs électriques (40) formés d'une pluralité d'unités isolateurs (50), dans lequel lesdits isolateurs (40) sont montés sur une ou plusieurs tours de transmission (20) pour isoler un ou plusieurs conducteurs de phase (30) desdites tours (20) ; dans lequel ledit procédé utilise des données obtenues à partir de dispositifs de surveillance (10), fixés sur le côté extérieur d'unités isolateurs sélectionnées (50), et
- dans lequel chaque dispositif de surveillance (10) comprend :
(i) une sonde à effet Hall (11), qui est apte à détecter un contournement électrique du conducteur de phase correspondant (30) et de la tour (20) qui maintient ce même conducteur de phase (30) ;
(ii) un ou plusieurs capteurs de champ électrique (12), pour capturer différentes parties de spectre des signaux radiofréquence (RF) générés à proximité de ladite unité isolateur (50) ;
(iii) un ou plusieurs capteurs de champ magnétique (13), chacun apte à enregistrer la grandeur du vecteur de champ magnétique dans l'orientation souhaitée à proximité de ladite unité isolateur (50) ;
(iv) un capteur d'accélération et d'inclinaison (14), apte à mesurer des données d'accélération et d'inclinaison, avec une détection de chute libre ;
(v) un capteur de température interne (18) de dispositif (10) ;
(vi) une unité de réseau étendu à basse consommation (LPWAN) (17), apte à échanger les données avec une ou plusieurs passerelles LPWAN (60) ;
(vii) une batterie (17) et le système de gestion de batterie correspondant ;
(viii) une unité de traitement (15) qui collecte les données provenant des sondes et capteurs énumérés ci-dessus, transmet les données acquises avec l'ID unique qui définit le dispositif, et immédiatement après une fin de session d'envoi reçoit les instructions par le biais de passerelles LPWAN (60) dudit système de traitement de données sur la manière de gérer les données dans la prochaine période de temps ; dans lequel ladite unité de traitement (15) est déclenchée par un ou plusieurs événements déclencheurs pour envoyer immédiatement les données sur son unité LPWAN (17), dans lequel lesdits événements déclencheurs se produisent lorsque les valeurs par défaut d'un ou plusieurs capteurs (12, 13, 14, 18) sont dépassées, ou le déclenchement est initié par la sonde à effet Hall (11) ou la détection de chute libre (14), ou lorsque le temps prédéfini pour l'envoi automatique a expiré ;
- dans lequel un ensemble de passerelles LPWAN (60) est disposé sur la ligne électrique de transmission sous surveillance pour assurer un échange de données sécurisé avec l'ensemble de dispositifs de surveillance (10), chaque passerelle LPWAN (60) est en outre connectée à Internet (90) ;
- dans lequel les données météorologiques sont obtenues à partir d'une ou plusieurs stations météorologiques (70), éventuellement disposées au-dessus des tours de transmission (20), et connectées directement à la couche Internet (90), ou par le biais des unités LPWAN dédiées aux passerelles LPWAN (60) ;
- éventuellement, un serveur de données de réseau (110), qui est connecté à la couche Internet (90), apte à fournir les données d'état de réseau à partir du système d'acquisition et de contrôle des données (SCADA) du réseau ;
- dans lequel un serveur (80), connecté à la couche Internet (90), exécute ledit procédé et fournit les données aux utilisateurs (100), connectés à Internet (90), concernant l'état de fonctionnement de l'ensemble surveillé d'isolateurs électriques (40) collectées à partir d'une pluralité de dispositifs de surveillance (10), de stations météorologiques (70) et, éventuellement, d'un serveur de données de réseau (110) ;
dans lequel lesdites étapes de procédé sont :
A. le préréglage de chaque dispositif (10') avec tous les événements déclencheurs désactivés, l'ID unique est généré pour ledit dispositif (10') et enregistré avec le serveur (80) avec la future position de montage de l'isolateur électrique correspondant (40) ;
B. une fois que le dispositif particulier (10') est physiquement fixé à l'unité isolateur dédiée (50) et activé, le dispositif (10') commence à collecter les données et envoie les données dans des intervalles de temps prédéfinis au serveur (80), dans lequel le serveur (80) active les déclencheurs et définit des valeurs par défaut pour tous les capteurs (12', 13', 14', 18') et la sonde (11') pour ledit dispositif (10') une fois que les données du dispositif collectées montrent que l'isolateur électrique actuel (40) et le conducteur de phase correspondant (30) sont opérationnels, et le dispositif (10') devient le dispositif (10) à l'étape C. ;
C. simultanément à l'étape A. ou à l'étape B., le serveur (80) collecte et stocke en permanence de nouvelles données obtenues à partir d'une pluralité de dispositifs (10), préalablement installés sur la partie opérationnelle ou non opérationnelle du réseau, qui envoie périodiquement des données au serveur (80) ;
D. le serveur (80) effectue en permanence des tâches analytiques, en utilisant les données nouvellement obtenues aux étapes C., les données obtenues à partir d'une ou plusieurs stations météorologiques (70), et éventuellement les données obtenues à partir du serveur de données de réseau (110), dans lequel le serveur (80) :
- vérifie les valeurs nouvellement reçues de chaque capteur ou sonde sur chaque dispositif (10) pris séparément, combine les valeurs reçues avec les données météorologiques pour l'emplacement dudit dispositif (10), et compare les valeurs nouvellement reçues avec les valeurs précédemment enregistrées pour le même dispositif (10) ;
- vérifie la corrélation de deux valeurs de capteur différentes nouvellement reçues, ou plus, appartenant au même dispositif (10) pris séparément, et combine en fin de compte lesdites données avec les données météorologiques pour l'emplacement dudit dispositif (10) ;
- vérifie la corrélation d'un ensemble identique de valeurs de capteur récemment reçues pour deux dispositifs (10, 10', 10", ...), ou plus, montés sur les isolateurs électriques (40, 40', 40", ...), fixés au même conducteur de phase (30), sur des mêmes ou différentes tours (20, 20', 20", ...) ; et
- vérifie la corrélation d'un ensemble identique de valeurs de capteur récemment reçues pour deux dispositifs (10, 10', 10", ...), ou plus, montés sur les isolateurs électriques (40, 40', 40", ...) fixés aux différents conducteurs de phase (30, 30', 30" ...), sur des mêmes ou différentes tours (20, 20', 20", ...) ;
E. toutes les nouvelles données obtenues à l'étape D. sont utilisées par le serveur (80) :
- pour mettre à jour les capteurs et les valeurs seuils de sonde pour le dispositif sélectionné (10) qui a besoin d'une telle action et génère le rapport d'intégrité du dispositif (10) correspondant, de sorte que le serveur (80) donne la priorité à la tâche de mise à jour des capteurs et des valeurs seuils de sonde pour le dispositif sélectionné (10) afin de réussir à renvoyer le message au dispositif sélectionné (10) tout en étant en mode réception ;
- pour générer le dernier rapport d'intégrité pour chaque isolateur (40) avec les recommandations concernant la maintenance, et le cas échéant, le serveur (80) génère une alarme qui est transmise à un ou plusieurs utilisateurs prédéfinis (100) ;
- pour générer le dernier rapport d'intégrité pour chaque conducteur de phase (30) ; et
- pour générer le dernier rapport d'intégrité et les recommandations pour la ligne électrique sous surveillance ;
dans lequel tous les rapports d'intégrité susmentionnés sont accessibles par un ou plusieurs utilisateurs (100) responsables de la surveillance dudit système de ligne électrique, et dans lequel lesdits rapports d'intégrité sont finalement indirectement confirmés par le biais de données reçues du serveur de données de réseau (110), si disponibles ;
dans lequel ledit procédé est **caractérisé en ce qu'**à l'étape D. :
I.) le serveur (80) vérifie la corrélation de deux valeurs de capteur différentes nouvellement reçues, ou plus, appartenant au même dispositif (10) et les états d'intégrité suivants de l'isolateur (40), portant ledit dispositif (10), sont enregistrés :
- la sonde à effet Hall (11) est déclenchée, et un ou plusieurs capteurs de champ électrique (12.i) enregistrent les variations du champ électrique sortant des valeurs initialement définies, et un ou plusieurs capteurs de champ magnétique (13.j) enregistrent les variations sortant des valeurs initialement définies ;
de tels enregistrements simultanés signalant une ou plusieurs causes énumérées ci-dessous :
(i) une fuite de courant à travers la partie mise à la terre, ou
(ii) une panne d'isolateur (40),
dans lequel l'état d'intégrité, généré à l'étape E., est le remplacement immédiat de l'isolateur (40) et l'alarme est envoyée à l'utilisateur dédié (100) ;
- la sonde à effet Hall (11) est déclenchée par les relevés du capteur d'accélération et d'inclinaison (14) qui sortent des seuils initialement fixés ; de tels enregistrements simultanés signalent une ou plusieurs causes énumérées ci-dessous :
(i) une décharge sur l'isolateur (40), ou
(ii) un choc physique causé par un arbre, la glace ou la neige, ou
(iii) un problème de vent,
dans lequel l'état d'intégrité, généré à l'étape E., est inchangé, sous réserve que lors du prochain contrôle de routine, cet isolateur (40) doive être vérifié ;
- la sonde à effet Hall (11) est déclenchée, un ou plusieurs capteurs de champ électrique (12.i) enregistrent les variations du champ électrique qui sortent des valeurs initialement fixées pendant l'augmentation observée de l'humidité relative de l'air ; de tels enregistrements simultanés signalant :
(i) des variations du champ électrique, dans lequel l'humidité provoque une décharge sur l'isolateur (40) ;
dans lequel l'état d'intégrité, généré à l'étape E., est inchangé, sous réserve que lors du prochain contrôle de routine, cet isolateur (40) doive être vérifié ; en recommandant d'effectuer la mesure du champ électrique à une humidité plus faible, uniquement si les valeurs observées sont rétablies après l'incident enregistré ;
- un ou plusieurs capteurs de champ électrique (12.i) enregistrent les variations du champ électrique qui sortent des valeurs initialement définies ainsi que le relevé anormal du capteur de température interne (18) ; de tels enregistrements simultanés signalent une ou plusieurs causes énumérées ci-dessous :
(i) une perturbation du champ électrique due à l'ionisation et aux particules de poussière provoquées par l'incendie, ou
(ii) des données météorologiques externes concernant l'humidité et la température sont extrêmes,
dans lequel l'état d'intégrité, généré à l'étape E., est inchangé, sous réserve que les événements déclencheurs soient ajustés par le serveur (80) pour ledit dispositif (10) et lui soient renvoyés, et le serveur (80) apprend le comportement de ce dispositif particulier (80) pour les données météorologiques observées ;
- le capteur d'accélération et d'inclinaison (14) signale la variation d'accélération et d'orientation sortant des seuils, ainsi qu'un relevé anormal du capteur de température interne (18) ; de tels enregistrements simultanés signalant une ou plusieurs causes énumérées ci-dessous :
(i) une fissuration de l'isolateur (40), ou
(ii) une fissuration de l'isolateur (40), sans problèmes de courts-circuits si le capteur de température interne (18) indique T<-20 °C, ou, T>35 °C et la tour (20) est située dans une zone karstique ;
dans lequel l'état d'intégrité, généré à l'étape E., est le remplacement immédiat d'un isolateur (40) et l'alarme est envoyée à l'utilisateur dédié (100) ;
- le capteur d'accélération et d'inclinaison (14) signale la variation d'accélération et d'orientation sortant des seuils, ainsi qu'un relevé anormal du capteur de température interne (18), la sonde à effet Hall (11) est déclenchée, et un ou plusieurs capteurs de champ électrique (12.i) et un ou plusieurs capteurs de champ magnétique (13.j) enregistrent des variations anormales du champs correspondants ; de tels enregistrements simultanés signalant la cause ci-dessous :
(i) une fissuration de l'isolateur (40),
dans lequel l'état d'intégrité, généré à l'étape E., est le remplacement immédiat d'un isolateur (40) et l'alarme est envoyée à l'utilisateur dédié (100),
**ou**
**II.)** le serveur (80) vérifie la corrélation d'un ensemble identique de valeurs de capteurs récemment reçues pour deux dispositifs (10, 10', 10", ...), ou plus, montés sur les isolateurs électriques (40, 40', 40", ...), fixés au même conducteur de phase (30), sur des mêmes ou différentes tours (20, 20', 20", ...) ; dans lequel des dispositifs deux par deux (10, 10') sont comparés :
- lorsqu'il est observé qu'un ou plusieurs capteurs de champ électrique (12.i) montrent une augmentation du champ électrique sur le dispositif (10) au fil du temps, en même temps que l'ensemble identique de capteurs de champ électrique (12.i') montre une diminution du champ électrique sur le dispositif (10') dans le même temps ; de tels enregistrements simultanés signalent une ou plusieurs causes énumérées ci-dessous :
(i) un endommagement mécanique de l'un des isolateurs (40, 40'), ou
(ii) un problème de mise à la terre de la tour (20) ou de la tour (20'), ou
(iii) une rupture de corde de protection,
dans lequel l'état d'intégrité, généré à l'étape E., est que les isolateurs (40, 40') ont besoin d'un nettoyage ou au moins d'une inspection visuelle lors du prochain contrôle ;
- lorsqu'il est observé qu'un ou plusieurs capteurs de champ électrique (12.i) montrent une augmentation de l'amplitude de champ électrique sur le dispositif (10) au fil du temps, en même temps que l'ensemble identique de capteurs de champ électrique (12.i') montre également une augmentation de l'amplitude de champ électrique sur le dispositif (10') en même temps ; de tels enregistrements simultanés signalent une ou plusieurs causes énumérées ci-dessous :
(i) un problème possible sur le conducteur de phase (30) ; ou
(ii) une tempête qui approche ; ou
(iii) un problème de foudre,
dans lequel l'état d'intégrité, généré à l'étape E., est que les conditions des isolateurs sont bonnes, mais il est signalé à l'opérateur du réseau de vérifier l'état de tension du réseau électrique,
**ou**
**III.)** le serveur (80) vérifie la corrélation d'un ensemble identique de valeurs de capteurs récemment reçues pour deux dispositifs (10, 10', 10", ...), ou plus, montés sur les isolateurs électriques (40, 40', 40", ...) fixés au conducteur de phase différent (30, 30', ...), sur des mêmes ou différentes tours (20, 20', 20", ...) ; dans lequel des dispositifs trois par trois (10, 10', 10") sont utilisés ;
- lorsqu'il est observé qu'un ensemble identique de capteurs de champ électrique (12.i) montre une augmentation du champ électrique sur les trois dispositifs (10, 10', 10") montés sur la même tour (20) ; de tels enregistrements simultanés signalent une ou plusieurs causes énumérées ci-dessous :
(i) un coup de foudre sur la tour (20) ; ou
(ii) un coup de foudre sur le fil de terre de la même tour (20) ;
dans lequel l'état d'intégrité, généré à l'étape E., est inchangé, et les isolateurs (40, 40', 40") nécessitent un contrôle de routine ;
- lorsqu'il est observé qu'un ensemble identique de capteurs de champ électrique (12.i, 12.i') montre une augmentation du champ électrique sur deux dispositifs (10, 10'), et que le même ensemble de capteurs de champ électrique (12.i") montre une diminution du champ électrique sur le troisième dispositif (10") ; de tels enregistrements simultanés signalent une ou plusieurs causes énumérées ci-dessous :
(i) un problème de troisième isolateur (40") ; ou
(ii) un problème de protection de ligne de transmission d'électricité ; ou
(iii) un coup de foudre dans l'un des conducteurs de phase ; dans lequel l'état d'intégrité, généré à l'étape E., est inchangé, et les isolateurs (40") et la protection de ligne de transmission d'électricité nécessitent un contrôle.

2. Système de traitement de données pour surveiller l'état de fonctionnement d'isolateurs électriques (40) comprenant des moyens pour mettre en œuvre le procédé selon la revendication 1.
